Europäisches Patentamt

European Patent Office

Office européen des brevets

(11) Numéro de publication: **0 310 463**
**A1**

## (12) DEMANDE DE BREVET EUROPEEN

(21) Numéro de dépôt: 88402044.7

(22) Date de dépôt: 04.08.88

(51) Int. Cl.⁴: **H 01 L 23/56**

(30) Priorité: 29.09.87 FR 8713416

(43) Date de publication de la demande:
05.04.89 Bulletin 89/14

(84) Etats contractants désignés:
BE DE ES FR GB IT NL SE

(71) Demandeur: BULL S.A.
121, Avenue de Malakoff
F-75116 Paris (FR)

(72) Inventeur: Dehaine, Gérard
25, avenue de la Grande Armée
F-75016 Paris (FR)

Kurzweil, Karel
25, avenue de la Grande Armée
F-75016 Paris (FR)

(74) Mandataire: Denis, Hervé et al
BULL S.A. Industrial Property Department 25 avenue de
la Grande-Armée
F-75016 Paris (FR)

(54) Boîtier pour circuit intégré de haute densité.

(57) Le boîtier 10 comprend une embase électriquement et thermiquement conductrice 20 portant la puce 12, des bornes d'alimentation 15a recevant un premier potentiel d'alimentation, et un réseau d'interconnexion 16 en céramique qui entoure la puce 12, qui porte les bornes de signaux 14 du boîtier 10 et les bornes d'alimentation 15b recevant un second potentiel d'alimentation, et qui incorpore les conducteurs de signaux et d'alimentation destinés à la puce 12 et un dispositif de découplage 17 incluant des condensateurs 19 et deux plans conducteurs 18a, 18b respectivement reliés aux bornes d'alimentation 15a, 15b. Le découplage par les condensateurs 19 se fait ainsi au plus près des plans conducteurs 18a et 18b et au plus près de la puce 12 au niveau des îlots 32a, 32b.

FIG. 1

**Description**

## Boîtier pour circuit intégré de haute densité

L'invention se rapporte à un boîtier pour un circuit intégré de haute densité encore appelé circuit VLSI (Very Large Scale Integration chip) ou puce.

L'invention s'applique au domaine de l'électronique, pour le montage d'un circuit intégré dans un dispositif de traitement de signaux et plus particulièrement pour la connexion d'un circuit intégré sur une carte de circuits imprimés d'un tel dispositif. Un circuit intégré de haute densité est ordinairement monté dans un boîtier comprenant au moins une embase thermiquement conductrice de support du circuit intégré, des bornes d'entrée-sortie, et un réseau d'interconnexion composé de conducteurs reliant les bornes d'entrée-sortie du boîtier au circuit intégré. Parmi les bornes d'entrée-sortie du boîtier, on distingue les bornes de signaux des bornes d'alimentation destinées à receuvoir divers potentiels électriques extérieurs prédéterminés. De même, dans le réseau d'interconnexion, on distingue les conducteurs de signaux des conducteurs d'alimentation qui servent à acheminer les potentiels d'alimentation jusqu'au circuit intégré.

Un boîtier pour circuit intégré de haute densité doit satisfaire à des conditions très contraignantes. D'une part, il doit réduire à une valeur minimale la composante réactive des conducteurs d'alimentation. Cela est ordinairement fait par un dispositif de decouplage incorporé au boîtier. Le dispositif de découplage comprend ordinairement des plans conducteurs reliés aux plaques d'au moins un condensateur de découplage et recevant respectivement les différents potentiels appliqués sur les bornes d'alimentation du boîtier. Le découplage effectif se fait au niveau des points de connexion des plans conducteurs avec les conducteurs connectés au condensateur. Compte tenu de la très faible self-induction des plans conducteurs, il s'ensuit que le découplage se fait aussi pratiquement au niveau des points de connexion des plans conducteurs avec les conducteurs d'alimentation du réseau d'interconnexion. Le découplage est donc d'autant plus efficace que ces derniers points de connexion sont proches du circuit intégré pour constituer des liaisons très courtes et, d'autre part, que le condensateur a une capacité élevée, sa self-induction interne est faible, et la self-induction de ses liaisons avec les plans conducteurs est également faible. On ajoute généralement, à l'action du dispositif de découplage sur les conducteurs d'alimentation, une fonction de distribution à faible résistance ohmique des potentiels d'alimentation par l'intermédiaire des conducteurs d'alimentation. Cette fonction est remplie essentiellement par les plans conducteurs du dispositif de découplage, qui rendent le boîtier presque insensible aux variations de l'énergie requise pour le bon fonctionnement du circuit intégré. D'autre part, le boîtier doit être le moins cher possible, grâce à des éléments pouvant être construits et montés simplement. Accessoirement, d'autres conditions peuvent être exigées, telles que la résistance mécanique du boîtier, son étanchéité et l'amovibilité de sa connexion.

Une solution connue visant à satisfaire à ces exigences est décrite dans la demande de brevet européen n° 0 166 634. Le boîtier est du type "chip carrier", comprenant une embase thermiquement conductrice de support du circuit intégré, des bornes de signaux et des bornes d'alimentation, un réseau d'interconnexion sous forme d'un cadre de céramique multicouche porté par l'embase et entourant le circuit intégré, et un dispositif de découplage constituant un couvercle en céramique qui recouvre le cadre du réseau d'interconnexion et qui inclut des plans conducteurs connectés à au moins un condensateur de découplage et à des points de connexion périphériques du réseau d'interconnexion. Ces points sont donc géométriquement éloignés du circuit intégré de toute la largeur du cadre, de sorte que la longueur électrique des conducteurs d'alimentation demeure relativement grande et produit encore une composante réactive (capacitive et selfique) élevée, préjudiciable au bon fonctionnement du circuit intégré. La structure de ce boîtier s'avère aussi relativement complexe, donc coûteuse, et encombrante. Il est à noter encore que ce boîtier n'est pas bien adapté au refroidissement du circuit intégré. Une bonne adaptation obligerait de disposer les bornes d'entrée-sortie du boîtier du côté du circuit imprimé de découplage et compliquerait considérablement la structure du boîtier.

Ce document antérieur illustre plus généralement les difficultés rencontrées par l'emploi de la céramique pour la fabrication d'un boîtier de haute performance pour un circuit intégré de haute densité. L'un des problèmes réside dans le retrait de la céramique co-cuite, qui limite la précision dans le positionnement des conducteurs dans une couche conductrice d'un réseau d'interconnexion en céramique. Cependant, la céramique est un matériau souvent préféré, à cause de ses bonnes caractéristiques électriques, de sa robustesse et de l'étanchéité qu'il procure.

L'invention présente une solution qui procure à un boîtier pour circuit intégré de haute densité un découplage efficace au plus près du circuit intégré, une structure simple, peu encombrante et bien adaptée à la céramique, et un refroidissement aisé du circuit intégré. Par conséquent, un boîtier conforme à l'invention peut être facilement fabriqué en grande série au moindre coût.

Selon l'invention, un boîtier pour un circuit intégré de haute densité, comprenant une embase thermiquement conductrice de support du circuit intégré, des bornes de signaux et des bornes d'alimentation, un réseau d'interconnexion porté par l'embase et entourant le circuit intégré, et un dispositif de découplage incluant des plans conducteurs couplés à au moins un condensateur de découplage et reliés auxdites bornes d'alimentation et au réseau d'interconnexion en une pluralité de points de connexion, est caractérisé en ce que le réseau d'interconnexion incorpore le dispositif de découplage.

Les caractéristiques et avantages de l'invention ressortiront de la description qui suit, donnée à titre d'exemple et faite en référence aux dessins annexés.

Dans les dessins :

- la figure 1 est une vue en coupe transversale d'un boîtier conforme à l'invention pour circuit intégré de haute densité, le boîtier étant monté sur une carte de circuits imprimés représentée partiellement et schématiquement ;

- la figure 2 est une vue en perpective éclatée du boîtier et de la carte représentés sur la figure 1 ;

- la figure 3 est une vue de détail agrandi suivant une demi-coupe médiane et une demi-coupe en diagonale du boîtier représenté sur les figures 1 et 2 ; et

- la figure 4 est une vue similaire à celle de la figure 1 d'une variante de réalisation d'un boîtier conforme à l'invention.

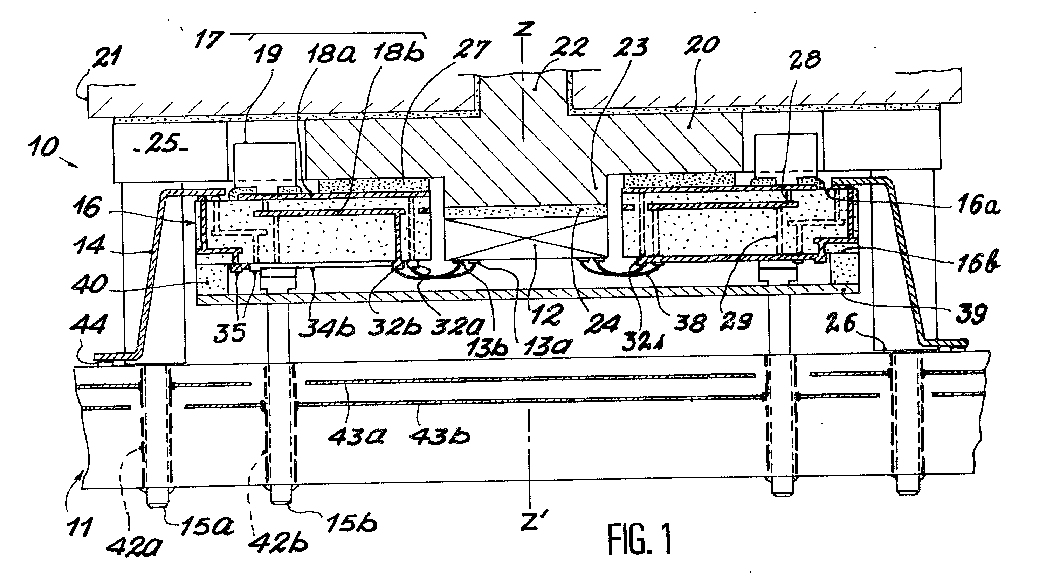

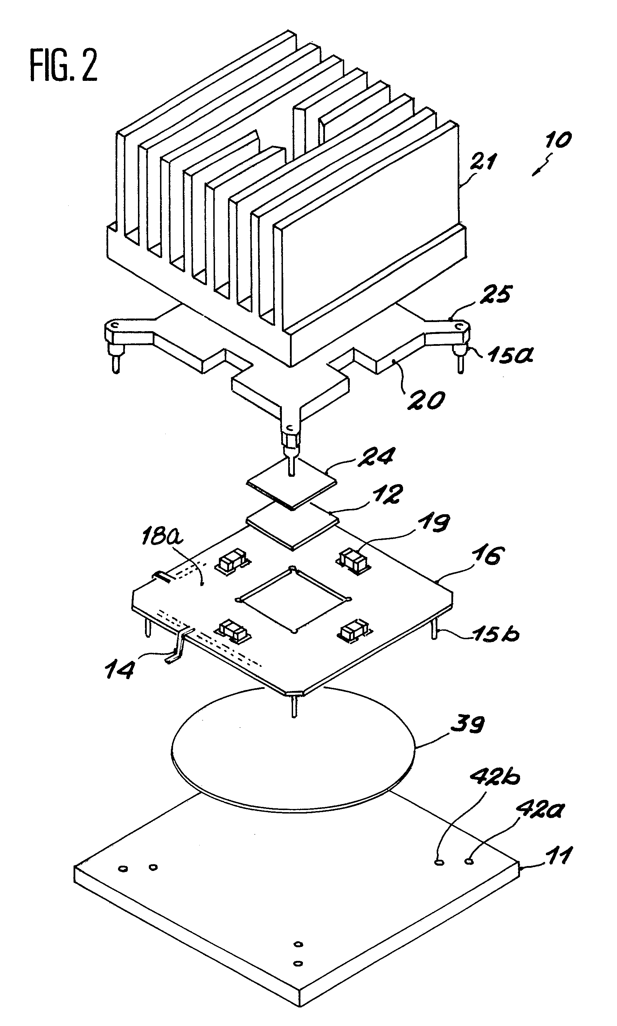

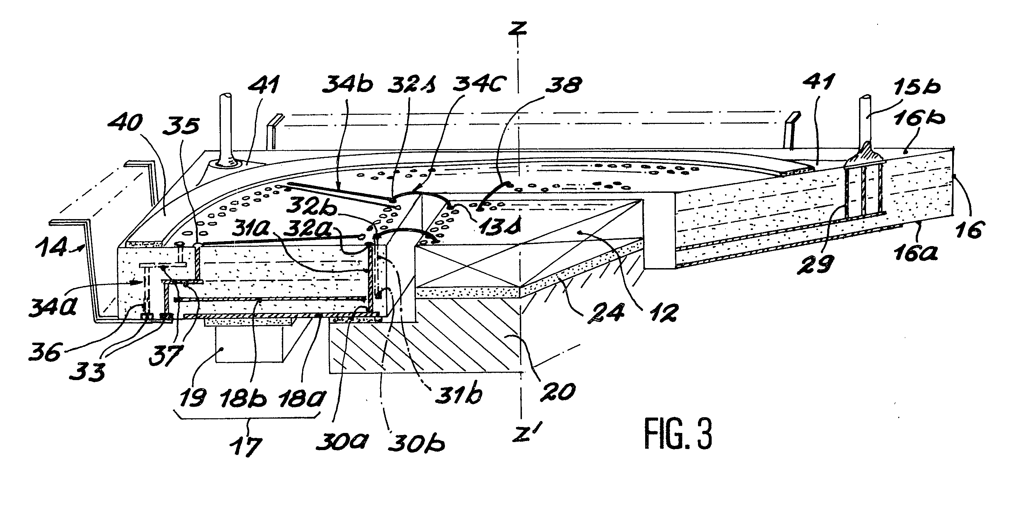

Les figures 1, 2 et 3 illustrent un exemple de boîtier 10 conforme à l'invention, représenté das sa position finale de connexion avec une carte de circuits imprimés 11 illustrée schématiquement et partiellement.

Le boîtier 10 est conçu pour l'encapsulation d'un circuit intégré de haute densité 2, couramment appelé puce. Actuellement, la puce 12 est ordinairement une plaquette mince de moins d'un millimètre d'épaisseur, et de forme sensiblement carrée d'un centimètre de côté environ. L'axe Z′Z est la droite perpendiculaire à la puce 12 en son centre. Sa face active présente des bornes d'entrée-sortie périphériques 13 disposées en quinconce comme illustré, ou en ligne. Les bornes 13 se composent de bornes d'entrée-sortie de signaux 13s et de premières et secondes bornes d'alimentation 13a, 13b destinées à recevoir respectivement deux potentiels différents, Va, Vb pour l'alimentation en énergie de la puce 12. Par exemple, le potentiel Va représente la masse et le potentiel Vb forme une tension de + 5 volts par rapport à la masse.

Le boîtier 10 de la puce 12 se compose essentiellement de bornes de signaux 14, de bornes d'alimentation 15 réparties en deux groupes 15a, 15b pour recevoir respectivement les deux potentiels Va et Vb, d'un réseau d'interconnexion 16 formé de tous les conducteurs nécessaires à la liaison entre les bornes 13 de la puce 12 et les bornes de signaux 14 et les bornes d'alimentation 15 du boîtier 10, d'un dispositif de découplage 17 incorporé au réseau d'interconnexion 16 et fait de deux plans conducteurs 18a, 18b couplés respectivement aux potentiels Va, Vb ainsi qu'aux plaques de quatre condensateurs de découplage 19, et d'une embase 20 thermiquement et électriquement conductrice, servant de support à la puce 12 et au réseau d'interconnexion 16 et constituant une interface thermique avec un dispositif de refroidissement tel que le radiateur 21.

Dans le boîtier 10 illustré, l'embase 20 est une plaque rigide sensiblement carrée coaxiale à l'axe Z′Z et de surface supérieure à celle de la puce 12 pour servir aussi de support au réseau d'interconnexion 16. L'embase 20 utilisée est une plaque de cuivre de quinze millimètres de côté et de deux millimètres d'épaisseur. Elle est pourvue d'une colonne 22 coaxiale à l'axe Z′Z et conçue pour la fixation du radiateur 21. De l'autre côté, elle présente un bossage 23 pour la fixation de la puce 12, par exemple par l'intermédiaire d'un joint de colle électriquement et thermiquement conductrice 24. Les parties médianes des quatre côtés de l'embase 20 sont échancrées pour loger les quatre condensateurs 19. Les coins de l'embase 20 se prolongent suivant les diagonales respectives de l'embase pour former quatre bras 25 porteurs des quatres bornes d'alimentation 15a. Les bornes 15a sont des pieux longs d'environ cinq millimètres, fixés à l'extrémité des bras 25 perpendiculairement à la face de l'embase 20 qui porte la puce 12, et pourvus d'épaulements 26 respectifs, équidistants de l'embase 20 pour servir de butée contre la carte 11 et assurer ainsi la connexion finale du boîtier 10 dans la carte.

Le réseau d'interconnexion 16 est un bloc multicouche de céramique en forme de cadre sensiblement carré, d'environ deux millimètres d'épaisseur, onze millimètres de côté intérieur et vingt sept millimètres de côté extérieur. Sa face 16a porte les bornes de signaux 14 du boîtier 10 ainsi que les condensateurs 19 et le plan conducteur 18a du dispositif de découplage 17. Le plan conducteur 18a est connecté électriquement à l'embase 20, avantageusement par une couche de brasure telle qu'une couche d'argent-cuivre 27 assurant en même temps la fixation du réseau d'interconnexion 16 à l'embase 20 coaxialement à la puce 12. Ainsi, le plan conducteur 18a reçoit le potentiel Va appliqué sur les bornes d'alimentation 15a par l'intermédiaire de l'embase 20 et de la couche 27. Sur la face 16a, l'une des plaques de chaque condensateur 19 est connectée au plan 18a. L'autre plaque est connectée par l'intermédiaire d'une traversée (via) 28 au plan conducteur 18b immédiatement sous-jacent au plan 18a. Le plan conducteur 18b est relié par des traversées 29 à quatre pieux fixés orthogonalement à la face 16b du réseau d'interconnexion 16 et constituant les bornes d'alimentation 15b recevant le potentiel Vb. Ces pieux sont des clous dont les têtes ont été soudées aux bords extérieurs des traversées correspondantes 29. D'autre part, les plans 18a et 18b sont respectivement en liaison en des points 30a et 30b avec des traversées 31a, 31b débouchant sur des îlots 32a, 32b disposés sur la périphérie intérieure de la face 16b en correspondance avec les bornes d'alimentation 13a, 13b du circuit intégré 12. Les bornes de signaux 14 sont des fils ou bandes minces régulièrement répartis sur chaque côté du réseau d'interconnexion 16. Leurs extrémités sont courbées sensiblement perpendiculairement à leur partie médiane pour être dans des plans parallèles à la face 16a. Les bornes de signaux 14 sont respectivement soudées par leurs extrémités sur des plages de connexion 33 disposées en quinconce sur deux lignes parallèles à la périphérie de la face 16a illustrée, ou éventuellement disposées en une seule ligne périphérique.

L'ensemble des conducteurs de signaux 34 reliant les plages de connexion 33 aux bornes 13 de la puce 12 se compose de trois parties 34a, 34b et 34c. La partie 34a relie les plages de connexion 33 de la face 16a à des plages de connexion correspondantes 35 sur la face 16b, par l'intermédiaire de traversées 36 et de deux couches conductrices superposées 37 s'étendant dans le réseau 16 sous les deux plans conducteurs 18a et 18b. Les plages de connexion illustrées 35 sont avantageusement placées en quinconce sur deux lignes parallèles périphériques, circulaires et concentriques à l'axe Z'Z de la puce 12. La seconde partie 34b des conducteurs de signaux s'étale sur la face 16b et relie les plages de connexion 35 à des îlots 32s disposés sur la périphérie intérieure de la face 16b en correspondance avec les bornes de signaux 13s du circuit intégré 12. Avantageusement, les îlots de signaux 32s et les îlots d'alimentation 32a, 32b ont la même disposition et le même pas que les bornes correspondantes 13s, 13a et 13b de la puce 12. Les conducteurs de signaux de la partie 34b sont des fils rayonnants essentiellement rectilignes. Etant donné le pas très faible des îlots 32a, 32b et 32s, les conducteurs de signaux 34b ne peuvent pas actuellement être formés selon la technique de la céramique co-cuite comme les couches 37 par exemple. Les conducteurs 34a sont donc formés après fabrication du réseau d'interconnexion 16 en céramique. Le mode de réalisation choisi a utilisé la technologie des couches minces. Une couche mince continue de matériau conducteur tel, par exemple à base de cuivre recouvert de nickel et d'or, a été pulvérisée sur la face 16b, puis gravée pour obtenir les conducteurs 34b et les îlots 32. Enfin, la troisième partie 34c des conducteurs de signaux se compose de fils de liaison 38 reliant les îlots 32a, 32b, 32s aux bornes correspondantes 13a, 13b, 13s de la puce 12 et soudés selon la technologie dite "wire bonding". Pour faciliter le soudage, la puce 12 est montée sur le bossage 23 de l'embase 20 de façon que les plots 13 soient sensiblement coplanaires avec les îlots 32 de la face 16b du réseau d'interconnexion 16.

Enfin, le boîtier 10 comporte un capot 39 destiné principalement à assurer l'herméticité de la cavité du boîtier et à protéger mécaniquement la puce 12. Le capot 39 illustré est une plaque métallique circulaire fixée à la face 16b par un joint 40 disposé concentriquement et extérieurement aux plages de connexion 35. Avantageusement, le capot 39 est en un matériau électriquement conducteur et le joint 40 est une brasure conductrice mise en contact avec une patte conductrice de liaison 41 connectée à au moins l'une des bornes d'alimentation 15b de la face 16b. Les pattes de liaison 41 illustrées sont des extensions des bords extérieures des traversées 29 sur lesquels sont fixées les bornes d'alimentation 15b. Le capot 39 s'ajoute ainsi au plan conducteur 18b.

La figure 1 illustre aussi le montage du boîtier 10 sur la carte 11. La carte 11 est pourvue de trous de connexion 42a, 42b placés respectivement en correspondance avec les pieux 15a, 15b du boîtier 10. Les trous de connexion 42a, 42b sont respectivement mis en liaison dans la carte 11 avec des couches 43a, 43b de distribution des tensions d'alimentation Va, Vb. D'autre part, la face de la carte 11 en vis-à-vis du boîtier 10 porte des plages 44 disposées en ligne et destinées à la connexion des extrémités libres des bornes de signaux 14 du boîtier 10. La connexion du boîtier 10 à la carte 11 consiste donc à enficher les pieux 15a, 15b dans les trous de connexion 42a, 42b jusqu'à ce que les épaulements 26 des pieux 15a viennent en butée contre la face correspondante de la carte 11 et à souder les bornes de signaux 14 sur les plages 44.

les avantages d'un boîtier conforme à l'invention ressortent clairement de la description précédente. L'avantage essentiel est donné par le dispositif de découplage 17 qui, grâce à son incorporation dans le réseau d'interconnexion 16, permet d'agir au niveau des points 30a, 30b à proximité de la puce 12. Les longueurs des conducteurs d'alimentation individuels relatifs aux bornes 13a et 13b de la puce 12 sont simplement les sommes respectives des traversées 31a, 31b (1 millimètre environ) et des fils de liaison 38 (1 millimètre environ) entre les îlots 32a, 32b et les bornes 13a, 13b. De plus, la self-induction de la très courte connexion des condensateurs 19 avec les plans conducteurs 18a et 18b est très faible. Par ailleurs, dans le dispositif de découplage 17 la connexion électrique de l'embase massive 20 avec le plan conducteur 18a et du capot 27 relativement massif avec le plan conducteur 18b réduit notablement la résistance ohmique de la distribution des potentiels d'alimentation Va et Vb et diminue encore la composante réactive du boîtier 10. Un autre avantage notable du boîtier 10 réside dans la simplicité de sa structure et de sa fabrication, du fait que le dispositif de découplage 17 se trouve incorporé au réseau d'interconnexion 16 et fabriqué de la même façon, selon la technologie de la céramique multicouche co-cuite. On notera aussi que le boîtier 10 demeure compact, grâce à la fabrication des conducteurs de signaux 34b selon la technologie des couches minces, qui surmonte les difficultés présentées part la céramique pour obtenir une forte densité de conducteurs dans une couche. L'embase 20 offre aussi l'avantage de pouvoir polariser la face arrière de la puce 12, si celle-ci est par exemple du type MOS (Métal Oxyde Semiconducteur). En outre, le montage orthogonal des pieux donne au boîtier 10 une bonne robustesse et un encombrement minimal. Enfin, le montage du boîtier 10 sur la carte 11 est simple et peut être amovible. Il suffit d'enficher les pieux d'alimentation 15a, 15b dans la carte 11 et de souder de manière classique les bornes de signaux 14 aux plages 44 de la carte.

De nombreuses variantes peuvent être apportées à l'exemple de réalisation du boîtier 10 représenté sur les figures 1, 2 et 3. Notamment, le potentiel d'alimentation Va pourrait aussi s'appliquer directement sur le réseau d'interconnexion 16 au lieu de l'embase 20 comme illustré. Parmi les quatre pieux 15b fixés sur le réseau d'interconnexion 16 représenté sur les figures 1 à 3, deux premiers pieux pourraient être portés au potentiel VA et deux seconds pieux être portés au potentiel Vb comme précédemment. Dans ce cas, les premiers pieux 15a seraient en liaison avec le plan conducteur 18a par l'intermédiaire de traversées similaires aux traversées 29 illustrées relatives aux seconds pieux 15b. Il ne serait plus nécessaire que l'embase 20 soit électriquement conductrice. En variante, le bossage 23 pourrait être un élément conducteur séparé de l'embase 20 mais solidaire d'un socle couvrant la surface de la couche conductrice 27. Le socle jouerait le rôle de liaison conductrice entre le plan conducteur 18a et la face arrière de la puce 12. Une autre variante pourrait consister aussi à fixer la puce 12 sur une extension de l'un des plans conducteurs 18a, 18b à l'intérieur du cadre formé par le réseau d'interconnexion 16. Si en outre les bornes d'alimentation 15a, 15b étaient solidaires du réseau d'interconnexion 16, l'embase 20 pourrait seulement servir de support et d'interface thermique.

Il est d'autre part évident que le nombre des bornes d'alimentation 15a et 15b peut être quelconque. A la limite, un boîtier 10 conforme à l'invention pourrait avoir une seule borne 15a et une seule borne 15b, et dans la variante précédente elles pourraient être toutes deux fixées au réseau d'interconnexion 16. Le capot 39 pourrait aussi être connecté au potentiel Va, au lieu de sa connexion illustrée au potentiel Vb. Dans le dispositif de découplage 17, les plans conducteurs 18a, 18b peuvent être disposés autrement, par exemple être tous deux incorporés dans la céramique. Ce cas est envisageable notamment lorsque l'embase 20 n'a pas à jouer le rôle d'élément de liaison électrique. L'embase peut alors être faite d'une céramique. Un seul condensateur de découplage 19 pourrait suffire. Par ailleurs, les fils de liaison 38 entre tous les îlots 32 et les bornes correspondantes 13 de la puce 12 pourraient être des éléments conducteurs rectilignes fixés parallèlement à la face active de la puce 12 (du type "beam leads"). Un tel montage pourrait par exemple être obtenu à partir d'un ruban TAB (Tape Automated Bonding). De l'autre côté du réseau d'interconnexion, les bornes de signaux 14 du boîtier 10 pourraient être disposées sur la face 16b au lieu de la face 16a. Dans l'exemple illustré, la disposition des bornes de signaux 14 sur la face 16a a pour avantage de réduire l'encombrement du réseau d'interconnexion 16. Cependant, comptetenu de toutes les variantes de réalisation d'un boîtier conforme à l'invention, la disposition des bornes de signaux 14 sur la face 16b pourrait s'avérer judicieuse. Enfin, il est clair que l'élément d'évacuation de chaleur 21 peut être autre chose que le radiateur illustré, tel que par exemple un élément d'interface avec un liquide réfrigérant.

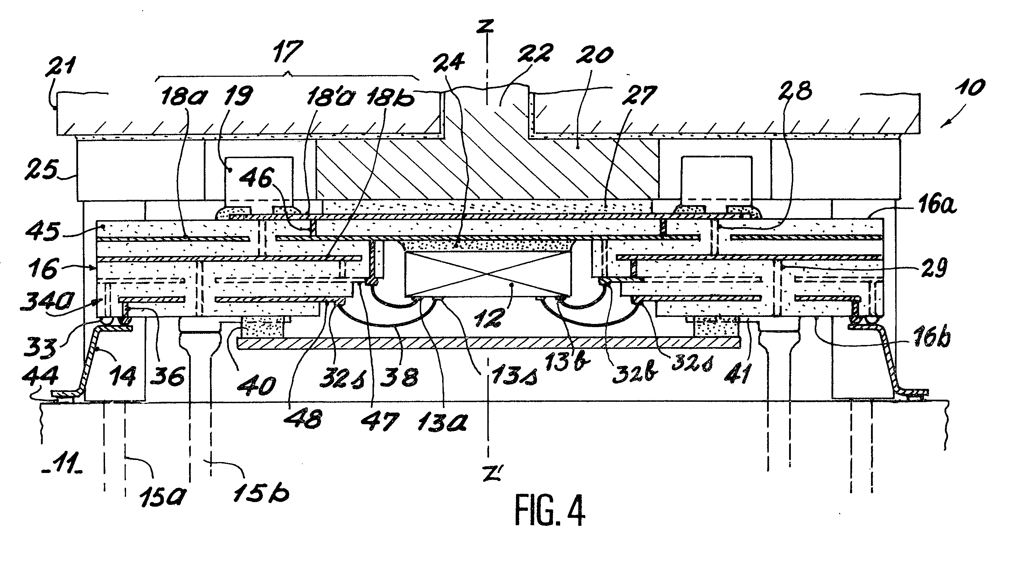

La figure 4 illustre de façon similaire à la figure 1 une variante de réalisation d'un boîtier 10 conforme à l'invention. Les élément communs avec le boîtier illustré dans les figures 1 à 3 sont référencés par les mêmes chiffres de référence. La variante essentielle de réalisation du boîtier 10 représentée sur la figure 4 réside dans la structure du réseau d'interconnexion 16 incorporant le dispositif de découplage 1. Le réseau d'interconnexion 16 est un bloc de céramique multicouche en forme de cadre concentrique à l'axe Z'Z de la puce 12, qui comporte une couche additionnelle de céramique 45 recouvrant le plan 18a et fermant la fenêtre formée par le cadre du réseau d'interconnexion 16. Le plan 18a recouvre l'ensemble de la couche 45. La puce 12 est collée sur le plan conducteur 18a par le joint de colle conductrice 24. La face extérieure de la couche 45 constitue la face 16a du réseau d'interconnexion 16. Elle est en grande partie recouverte par une couche conductrice constituant un plan conducteur auxiliaire 18'a du dispositif de découplage 17. Le plan auxiliaire 18'a est en liaison avec le plan 18a par l'intermédiaire de traversées 46 de façon à recevoir le potentiel d'alimentation Va. Les quatre condensateurs 19 reposent sur la face 16a, en ayant une plaque connectée sur la face 16a au plan auxiliaire 18'a et l'autre plaque reliée au plan conducteur 18b par la traversée 28. Comme dans le boîtier 10 précédent, la couche conductrice 27 fixe le réseau d'interconnexion 16 à l'embase 20 tout en assurant la liaison électrique entre le plan conducteur auxiliaire 18'a et les bornes d'alimentation 15a de l'embase 20. La couche 27 peut aussi être faite d'une brasure argent-cuivre. De préférence, on utilisera une colle conductrice à base d'argent, comme la colle du joint 24, à cause de la commodité de cette fixation.

La structure du réseau d'interconnexion 16 représenté sur la figure 4 diffère également par la disposition des îlots 32a, 32b et 32s qui sont en liaison avec les bornes correspondantes 13a, 13b et 13s de la puce 12. Tous les îlots 32 sont répartis sur deux gradins 47, 48 formés à la périphérie intérieure du réseau d'interconnexion 16 coaxialement à l'axe Z'Z. Le gradin inférieur 47 voisin de la puce 12 inclut avantageusement tous les îlots d'alimentation 32a, 32b représentatifs des potentiels d'alimentation Va et Vb. Les plans conducteurs 18a, 18b du dispositif de découplage 17 sont donc respectivement en liaison, aux points de connexion 30a et 30b, avec les traversées 31a 31b débouchant sur les îlots 32a et 32b répartis sur le gradin inférieur 47. Ainsi, la longueur des fils de liaison 38 entre les îlots 32a, 32b et les bornes 13a, 13b de la puce 12 est très courte par rapport aux autres fils relatifs au gradin supérieur 48 et contribue à réduire leur composante réactive propre. Les îlots de signaux 32s occupent le gradin supérieur 48 et complètent le gradin inférieur 47 de façon que la disposition de l'ensemble des îlots 32 corresponde avec celle de l'ensemble des bornes 13 de la puce 12. De préférence, l'ensemble des îlots 32 aura le même pas que les bornes 13 de la puce 12.

Enfin, le réseau d'interconnexion 16 représenté sur la figure 4 présente la caractéristique de porter l'ensemble des bornes de signaux 14 sur sa face 16b proche de la carte 11. Les bornes de signaux 14 constituent un ensemble de broches (lead frame) comme dans le boîtier précédent. Il sera cependant plus avantageux de les monter selon la technologie TAB, mettant en oeuvre un procédé simple, compact et fiable grâce à la présence possible d'une bande isolante liant entre elles les extrémités libres des bornes de signaux.

Il est aussi à noter que l'ensemble des conducteurs de signaux reliant les bornes de signaux 14 aus îlots 32s est totalement incorporé dans la céramique et fabriqué par conséquent selon la technologie de la céramique co-cuite. En d'autres termes, la fabrication du réseau d'interconnexion 16 représenté sur la figure 4 évite l'emploi additionnel de la technologie des couches minces qui était requis pour la formation des conducteurs 34b sur la face 16b.

Le boîtier 10 représenté sur la figure 4 constitue le mode de réalisation préféré de l'invention. Le réseau d'interconnexion 16 est fabriqué selon la technique classique de la céramique co-cuite. Il est très compact. En outre, il peut être équipé de la puce 12 indépendamment de l'embase 20, de sorte qu'avantageusement on équipera d'abord le réseau d'interconnexion 16 de la puce 12, de ses fils de liaison 38, du capot 39 et des condensateurs 19, puis on fixera au moyen de la couche 27 le réseau d'interconnexion équipé 16 à l'embase 20.

Bien entendu, toutes les variantes de réalisation mentionnées précédemment en référence au boîtier 10 représenté sur les figures 1 à 3 s'appliquent au boîtier 10 représenté sur la figure 4. Dans ce dernier boîtier, toutefois, on notera que le plan conducteur 18a a essentiellement pour fonction de polariser la face arrière de la puce 12. Par conséquent, si la puce ne requiert pas une telle polarisation, le plan 18a peut être supprimé et se substituer ainsi au plan conducteur auxiliaire 18'a. D'autre part, l'ensemble des îlots peuvent être répartis sur plus de deux gradins, ou seulement sur un gradin où ils seraient alors en quinconce. Ces possibilités dépendent notamment de la densité désirée des îlots 32 et de l'adaptation de la céramique co-cuite à cette densité.

## Revendications

1. Boîtier (10) pour un circuit intégré de haute densité (12), comprenant une embase thermiquement conductrice (20) de support du circuit intégré, des bornes de signaux (14) et des bornes d'alimentation (15a, 15b), un réseau d'interconnexion (16) porté par l'embase et entourant le circuit intégré, et un dispositif de découplage (17) incluant des plans conducteurs (18a, 18b) couplés à au moins un condensateur de découplage (19) et reliés auxdites bornes d'alimentation et au réseau d'interconnexion en une pluralité de points de connexion (30a, 30b), caractérisé en ce que le réseau d'interconnexion incorpore le dispositif de découplage.

2. Boîtier selon la revendication 1, caractérisé en ce que lesdits plans conducteurs du dispositif de découplage se superposent à au moins une couche conductrice de signaux (34b, 37) du réseau d'interconnexion.

3. Boîtier selon la revendication 2, caractérisé en ce que le réseau d'interconnexion forme avec le dispositif de découplage un bloc multicouche de céramique portant lesdites bornes de signaux (14) et au moins en partie lesdites bornes d'alimentation (15a, 15b) du boîtier.

4. Boîtier selon la revendication 2 ou 3, caractérisé en ce que le réseau d'interconnexion présente extérieurement des îlots d'alimentation (32a, 32b) reliés aux plans conducteurs (18a, 18b) du dispositif de découplage en lesdits points de connexion (30a, 30b) proches du circuit intégré (12) et des îlots de signaux (32s) connectés à au moins ladite couche conductrice de signaux (34b, 37), l'ensemble des îlots (32a, 32b, 32s) étant disposé à proximité du circuit intégré et connecté aux bornes correspondantes d'alimentation (13a, 13b) et de signaux (13s) du circuit intégré.

5. Boîtier selon la revendication 4, caractérisé en ce que l'ensemble des îlots est disposé sur au moins un gradin (47, 48) ménagé dans une face du réseau d'interconnexion à proximité du circuit intégré.

6. Boîtier selon la revendication 5, caractérisé en ce que l'ensemble des îlots étant réparti sur au moins deux gradins (47, 48), les îlots d'alimentation (32a, 32b) sont disposés sur le gradin inférieur le plus proche du circuit intégré.

7. Boîtier selon la revendication 4, caractérisé en ce que l'ensemble des îlots est disposé sur une face (16b) du réseau d'interconnexion, les îlots de signaux (32s) étant les extrémités de conducteurs rayonnants de ladite couche conductrice (34b) du réseau d'interconnexion, formée sur ladite face du réseau d'interconnexion et connectée aux bornes de signaux (14) du boîtier.

8. Boîtier selon la revendication 7, caractérisé en ce que la couche conductrice précitée est formée selon la technologie des couches minces.

9. Boîtier selon la revendication 7 ou 8, caractérisé en ce que la couche conductrice précitée est connectée aux bornes de signaux du boîtier par l'intermédiaire d'au moins une autre couche conductrice (37) du réseau d'interconnexion.

10. Boîtier selon l'une des revendications 1 à 9, caractérisé en ce que le dispositif de découplage comporte l'embase précitée (20), formée d'une plaque électriquement conductrice et en liaison avec au moins une première borne d'alimentation (15a) représentative d'un premier potentiel extérieur (Va) parmi lesdites bornes d'alimentation.

11. Boîtier selon la revendication 10, caractérisé en ce que l'embase (20) porte au moins ladite première borne d'alimentation (15a) et est en liaison électrique avec un premier plan conducteur (18a, 18'a) parmi lesdits plans conducteurs incorporés au réseau d'interconnexion.

12. Boîtier selon la revendication 11, caractérisé en ce que le premier plan conducteur précité est formé sur une face (16a) du réseau d'interconnexion et la liaison électrique précitée est faite d'une couche conductrice fixant le réseau d'interconnexion à l'embase.

13. Boîtier selon l'une des revendications 1 à 12, caractérisée en ce que le réseau d'interconnexion comporte un capot métallique conducteur (39) couplé à au moins l'une desdites bornes d'alimentation et ainsi incorporé au dispositif de découplage.

14. Boîtier selon la revendication 13, caractérisé en ce que le capot (39) est couplé à au moins une seconde borne d'alimentation (15b) représentative d'un second potentiel d'alimentation (Vb) différent du premier potentiel d'alimentation (Va) précité.

15. Boîtier selon l'une des revendications 1 à 14, caractérisé en ce que les bornes d'alimentation (15a, 15b) sont des pieux métalliques montés parallèlement à l'axe (Z'Z) du circuit intégré.

16. Boîtier selon la revendication 15, caractérisé en ce que les pieux (15a) présentent une butée (26) définissant la connexion finale du boîtier dans une carte (11).

17. Boîtier selon l'une des revendications 1 à 16, caractérisé en ce que l'embase (20) constitue un élément de polarisation de la face arrière du circuit intégré.

18. Boîtier selon l'une des revendications 1 à 16, caractérisé en ce que le circuit intégré est fixé à l'un (18a) des plans conducteurs incorporés au réseau d'interconnexion.

19. Boîtier selon l'une des revendications 1 à 18, caractérisé en ce que le réseau d'interconnexion porte ledit condensateur (19) sur l'une de ses faces.

FIG. 1

EP 0 310 463 A1

FIG. 2

FIG.3

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | IBM TECHNICAL DISCLOSURE BULLETIN, vol. 24, no. 1A, juin 1981, page 46, Armonk, NY, US; J.R. CAVALIERE et al.: "High-performance single-chip module" --- | 1-4,7,8 ,18,19 | H 01 L 23/56 |
| A | PATENT ABSTRACTS OF JAPAN, vol. 9, no. 288 (E-358)[2011], 15 novembre 1985; & JP-A-60 130 148 (MITSUBISHI DENKI K.K.) 11-07-1985 * Résumé * --- | 1-3,19 | |
| A | EP-A-0 154 757 (FUJITSU) * En entier * --- | 13 | |
| A | US-A-4 396 935 (SCHUCK) * Figure 8 * --- | 15 | |
| D,A | EP-A-0 166 634 (COMPAGNIE D'INFORMATIQUE) --- | | |
| A | EP-A-0 083 405 (IBM) --- | | DOMAINES TECHNIQUES RECHERCHES (Int. Cl.4) |
| A | US-A-4 330 683 (BELL TELEPHONE LABS) --- | | H 01 L |
| A | EP-A-0 081 419 (FAIRCHILD) ----- | | |

Le présent rapport a été établi pour toutes les revendications

| Lieu de la recherche | Date d'achèvement de la recherche | Examinateur |
|---|---|---|
| LA HAYE | 28-11-1988 | CAMPLING N.C.G. |